# EUROPEAN PATENT APPLICATION

(11) **EP 3 264 866 A1**
(43) Date of publication of application: **03.01.2018**
(21) Application number: 16755415.3
(22) Date of filing: 22.02.2016
(51) Int. Cl.: H05H 1/24, B01J 19/08, C23C 16/455, C23C 16/511, C23C 16/513, H05H 1/46

(54) **MICROWAVE PLASMA TREATMENT APPARATUS**

(30) Priority: 27.02.2015 JP 2015038677
(71) Applicant: National Institute of Advanced Industrial Science and Technology, Tokyo 100-8921 (JP)
(72) Inventor: KIM Jaeho, Tsukuba-shi Ibaraki 305-8568 (JP); SAKAKITA Hajime, Tsukuba-shi Ibaraki 305-8568 (JP)
(74) Representative: Graf von Stosch, Andreas
(86) International application number: PCT/JP2016/055064
(87) International publication number: WO 2016/136669

(57) **Abstract**

[Problem] To provide a microwave plasma treatment apparatus that is not provided with complicated, long gas flow paths inside a dielectric substrate, to stabilize generation and retention of a plasma, and can generate a highly uniform, high-density, stable low-temperature plasma not only at low atmospheric pressures but also at middle atmospheric pressures and high atmospheric pressures.

[Solution] In a micro plasma treatment apparatus including a dielectric substrate, a microwave introducing section, a microstrip line, an earth conductor, a gas inlet, a plasma generating section, and a nozzle for blowing out a plasma, the gas inlet is provided at the earth conductor or the microstrip line, and the gas inlet is provided with a diameter preferably smaller than a cut-off wavelength determined depending on a cross-section of the gas inlet, to prevent leakage of a microwave.

## Description

### Technical Field

The present invention relates to a microwave plasma treatment apparatus that is configured to generate a plasma by a microwave power to apply treatments such as CVD (chemical vapor deposition), etching, ashing (resist ashing treatment), and plasma nitriding and, for example, air cleaning to a treatment target substrate such as a wafer using the plasma.

### Background Art

In recent years, plasma treatment techniques have become indispensable in many fields of materials development and production technology. Plasma can generate high density radicals while keeping a high non-thermal equilibrium. Therefore, plasma is widely used in low temperature dry process technology.

Plasma jet is used as one of plasma sources at low atmospheric pressures (1 torr or lower) and pressures between middle atmospheric pressures (from 1 torr through 100 torr) and the atmospheric pressure. Plasma jet is a plasma blown out from a nozzle of an apparatus. Therefore, plasma jet is useful for applying CVD (chemical vapor deposition), etching, ashing, (resist ashing treatment), plasma nitriding and treatments such as air cleaning and sterilization/disinfection to a treatment target substrate such as a wafer using a plasma.

Currently, for generating a plasma jet, a method using a direct-current arc discharge or a direct-current pulse discharge is well-known. However, the method using a direct-current arc discharge or a direct-current pulse discharge has various problems such as that electrodes easily deteriorate and that reactive gases cannot be used.

Further, a method using a dielectric barrier discharge is well-known. However, the method using a dielectric barrier discharge has various problems such as that a filament-shaped discharge is generated and that high density radicals cannot be generated.

Furthermore, an electrodeless plasma jet generating apparatus is also known. For example, there has been proposed an inductive-coupling thermal plasma generating apparatus using a high frequency in a VHF band (from 30 MHz through 300 MHz) (see PTL 1). However, the proposed plasma jet generating apparatus has complicated impedance matching, cannot be upsized due to a structural problem, and has various limitations and problems in the production and operation of the apparatus because the apparatus uses a high-voltage electric circuit.

Meanwhile, there are the following advantages in the generation of a plasma jet using a microwave.
(1) A microwave power source is inexpensive.
(2) Electrodeless operation is possible and a life duration for which a discharge is retained is long.
(3) Impedance matching is possible with simple elements.
(4) Efficiency of coupling between a microwave and a plasma is good.
(5) Radiation loss to the outside is low, and power can be concentrated to where it is needed.
(6) A stable, high-density plasma is generated in a wide pressure range including the atmospheric pressure.

However, an existing plasma generating apparatus using a microwave power uses a waveguide, which is a metal tube, as a microwave transmission line, and has problems such as that the microwave transmission circuit is structurally large and expensive, and that operation at a low power is difficult.

Recently, there have been proposed methods for producing a plasma jet generating apparatus using a microstrip line, which is a low-power microwave transmission line, instead of the existing waveguide (see PTLs 2 and 3 and NPLs 1 and 2).

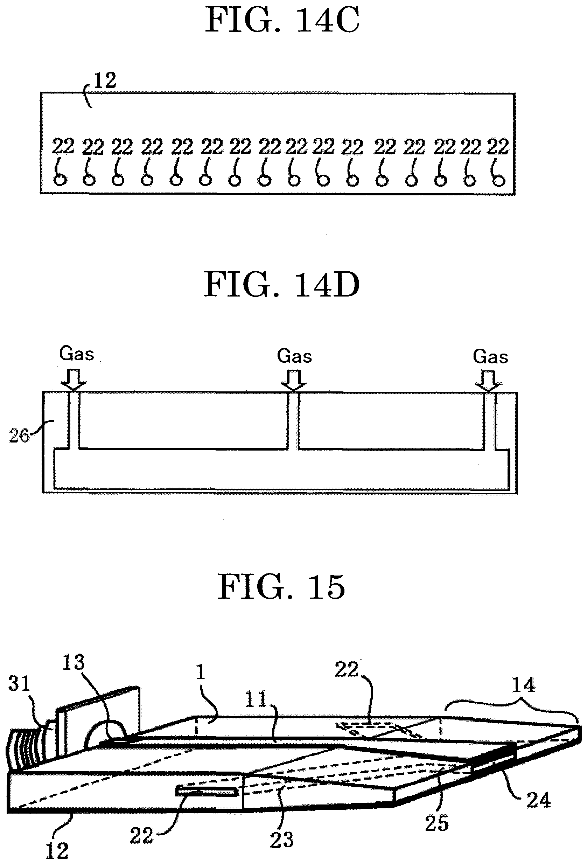

FIG. 15 illustrates a perspective view of an example of an existing plasma jet generating apparatus using a microstrip line. This apparatus includes: a microwave introducing section 13 provided on a cross-section at one end of a dielectric substrate 1; a taper section 14 formed toward the other end of the dielectric substrate 1; gas flow paths 23 formed inside the dielectric substrate 1; a microstrip line 11 for microwave power transmission provided on one surface of the dielectric substrate 1; an earth conductor 12 covering the other surface of the dielectric substrate 1; a plasma generating section 25 provided between the microstrip line 11 and the earth conductor 12; and a nozzle 24 configured to discharge a plasma.

In the plasma get generating apparatus, gases are introduced from two gas inlets 22 and 22 provided on the side surfaces of the dielectric substrate 1, pass through the gas flow paths 23 and 23, and merge at the plasma generating section 25, to be blown out from the nozzle 24 having a width of 10 mm to the outside of the dielectric substrate 1.

A microwave (2.45 GHz) power is introduced into the dielectric substrate 1 through a coaxial microwave connect 31, propagates between the microstrip line 11 and the earth conductor 12, and concentrates to the plasma generating section 25. As a result, a plasma is generated and blown out to the outside of the dielectric substrate 1 from the nozzle 24 together with the gas flow.

Meanwhile, in order to improve productivity in the plasma processes, development of a plasma jet having a wide width and capable of applying plasma treatment to a large area is strongly demanded. Structurally, it is possible to upsize the plasma generating apparatus using a microstrip line described above, by arraying microstrip lines based on their shared use of, for example, the dielectric substrate and the earth conductor (see PTL 2). Therefore, future prospects are expected for the apparatus.

### Citation List

### Patent Literature

PTL 1: Japanese Patent Application Laid-Open (JP-A) No. 2003-109795
PTL 2: JP-A No. 2007-299720
PTL 3: JP-A No. 2008-282784

### Non-Patent Literature

NPL 1: Susanne Schemer, et. al., "An improved microstrip plasma for optical emission spectrometry of gaseous species", Spectrochimica Acta Part B: Atomic Spectroscopy, Vol. 56, pp. 1585-1596 (2003).
NPL 2: Jaeho Kim, et. al., "Microwave-excited atmospheric-pressure plasma jets using a microstrip line", Applied Physics Letters, Vol. 93, 191505 (2008).

### Summary of Invention

### Technical Problem

However, the existing plasma apparatus using a microstrip line includes complicated, long gas flow paths inside the dielectric, because the gas inlets are provided on the side surfaces of the dielectric. This requires a high-level technique for processing the dielectric. As a result, there is a problem that a lot of production time and costs are required.

Further, the long gas flow paths provided inside the dielectric produce a wide surface over which the characteristic impedance of microwave propagation is discontinuous. Therefore, there occurs a high reflected wave of the microwave in the microwave propagation, to impart adverse influences to impedance matching. As a result, generation and retention of a plasma may become unstable.

Furthermore, existing low-temperature treatments using a plasma have been performed at low atmospheric pressures (1 torr or lower). Therefore, not only has an expensive high-vacuum system been required to add to system costs, but also the treatments have been time-consuming, resulting in high product costs. This has been industrially disadvantageous. Hence, a method for generating a non-thermal equilibrium plasma at a higher pressure than that, namely middle atmospheric pressures (from 1 torr through 100 torr) or high atmospheric pressures (from 100 torr through 760 torr) has been demanded.

Hitherto, there has not been developed a specific technique for upsizing a plasma jet, for example, a method for supplying a uniform gas flow to a nozzle having a wide width. Therefore, it has been difficult to provide a plasma jet having a wide width.

In view of the circumstances described above, the present invention has an object to provide a microwave plasma treatment apparatus that is not provided with complicated, long gas flow paths inside a dielectric substrate, to stabilize generation and retention of a plasma. The present invention also has an object to provide a microwave plasma treatment apparatus that can stably generate a low-temperature plasma jet having a wide width at not only low atmospheric pressures but also middle atmospheric pressures and high atmospheric pressures up to the atmospheric pressure.

### Solution to Problem

As a result of a series of earnest studies for achieving the objects described above, the present inventors have found that providing the earth conductor or the microstrip line with a gas inlet for supplying a gas to the plasma generating section makes it possible to remove the complicated, long gas flow paths from the inside of the dielectric substrate and to do without a high-level technique for processing the dielectric, which can save the production time and costs. The present inventors have also found that making the size of the gas inlet smaller than a cut-off wavelength makes it possible to prohibit a microwave from penetrating the gas inlet and to supply a gas to the plasma generating section without imparting influence to the microwave propagation characteristic.

The present invention has been completed based on these findings. According to the present invention, the following inventions are provided.

That is, one main feature of a microwave plasma treatment apparatus of the present invention is that it includes:
a dielectric substrate;
a microstrip line provided from one end to the other end of a first surface of the dielectric substrate, the first surface being any one of a front surface and a back surface of the dielectric substrate;
an earth conductor provided from one end to the other end of a second surface of the dielectric substrate opposite to the first surface;
a microwave introducing section provided at one end of the dielectric substrate and configured to introduce a microwave to between the microstrip line and the earth conductor;
a plasma generating section that is a space in which a plasma is generated by the microwave introduced from the microwave introducing section, and is a space provided between the microstrip line and the earth conductor;
a gas inlet provided at the earth conductor or the microstrip line and configured to supply a gas to the plasma generating section; and
a nozzle configured to discharge the plasma generated by the gas supplied to the plasma generating section and the microwave from the other end of the dielectric substrate.

Another feature of the microwave plasma treatment apparatus of the preset invention is that it includes:
the gas inlet having a diameter smaller than a cut-off wavelength determined depending on a cross-section of the gas inlet.

Another feature of the microwave plasma treatment apparatus of the present invention is that the first surface or the second surface of the dielectric substrate is provided with a groove in which the microstrip line or the earth conductor is embedded.

Another feature of the microwave plasma treatment apparatus of the present invention is that the dielectric substrate includes a taper section having a shape gradually decreasing in thickness toward the other end of the dielectric substrate.

Another feature of the microwave plasma treatment apparatus of the present invention is that the earth conductor or the microstrip line is provided with 2 or more gas inlets to which gases of different kinds are supplied, to enable a plasma discharge characteristic or a plasma treatment characteristic to be varied.

Another feature of the microwave plasma treatment apparatus of the present invention is that the earth conductor or the microstrip line is provided with 2 or more gas inlets, any one of which is provided with a liquid material vaporizing/supplying unit, to transform a liquid material into a plasma.

Another feature of the microwave plasma treatment apparatus of the present invention is that it includes:
a second dielectric substrate provided in contact with a surface of the dielectric substrate provided with the microstrip line;
a second earth conductor provided from one end to the other end of the second dielectric substrate;
a second plasma generating section that is a space provided between the microstrip line and the second earth conductor;
a second gas inlet provided at the second earth conductor to supply a gas to the second plasma generating section; and
a second nozzle configured to discharge a plasma generated by the gas supplied to the second plasma generating section and a microwave from the other end of the second dielectric substrate.

Another feature of the microwave plasma treatment apparatus of the present invention is that a long, elongate plasma is generated by a plurality of apparatuses arranged side by side based on their shared use of the dielectric substrate and the earth conductor, each of the plurality of apparatuses being the microwave plasma treatment apparatus.

Another feature of the microwave plasma treatment apparatus of the present invention is that it is configured to be supplied with a rare gas, or a reactive gas, or a mixture gas of a rare gas and a reactive gas to generate a plasma at a low atmospheric pressure, or a middle atmospheric pressure, or a high atmospheric pressure.

### Advantageous Effects of Invention

The microwave plasma treatment apparatus of the present invention can generate and retain a stable plasma jet having a wide width not only at a low atmospheric pressure, but also at a middle atmospheric pressure and a high atmospheric pressure. As a result of this, the microwave plasma treatment apparatus of the present invention can perform material processing such as wide area surface reformation, etching, ashing, cleaning, oxidizing/nitriding, and CVD (Chemical Vapor Deposition) film formation using a microwave-excited plasma jet having a wide width at the atmospheric pressure (or a low atmospheric pressure or a middle atmospheric pressure).

### Brief Description of Drawings

FIG. 1 is a perspective view of a microwave plasma treatment apparatus representing an Example of a first embodiment of the present invention;
FIG. 2 is a vertical cross-sectional view of the microwave plasma treatment apparatus illustrated in FIG. 1;
FIG. 3 is a cross-sectional view of a microwave plasma treatment apparatus in which a microwave introducing section is provided at an earth conductor, in another Example of the first embodiment of the present invention;
FIG. 4 is an exemplary view of a dielectric substrate provided with a groove in which a microstrip line is embedded, in another Example of the first embodiment of the present invention;
FIG. 5 is a cross-sectional view of a plasma treatment apparatus in which a plasma generating section and a nozzle are provided in contact with an earth conductor plate, in another Example of the first embodiment of the present invention;
FIG. 6 is a perspective view of a microwave plasma treatment apparatus representing an Example of a second embodiment of the present invention;
FIG. 7 is a perspective view of a microwave plasma treatment apparatus representing an Example of a third embodiment of the present invention;
FIG. 8 is a vertical cross-sectional view of the microwave plasma treatment apparatus illustrated in FIG. 7;
FIG. 9 is a vertical cross-sectional view of a microwave plasma treatment apparatus an Example of a fourth embodiment of the present invention;
FIG. 10 is a vertical cross-sectional view of a microwave plasma treatment apparatus provided with a liquid material vaporizing/supplying unit, in an Example of the fourth embodiment of the present invention;
FIG. 11 is a vertical cross-sectional view of a microwave plasma treatment apparatus representing an Example in which a fifth embodiment of the present invention is applied to the first embodiment;
FIG. 12 is a vertical cross-sectional view of a microwave plasma treatment apparatus representing an Example in which the fifth embodiment of the present invention is applied to the third embodiment;
FIG. 13A and FIG. 13B are exemplary views of a microwave plasma treatment apparatus representing an Example of a sixth embodiment of the present invention;
FIG. 14A, FIG. 14B, FIG. 14C, and FIG. 14D are exemplary views of a microwave plasma treatment apparatus representing an Example of a seventh embodiment of the present invention; and
FIG. 15 is a perspective view illustrating an example of an existing microwave plasma treatment apparatus using a microstrip line.

### Description of Embodiments

### <Embodiment 1>

A plasma treatment apparatus representing a first embodiment of the present invention is a microwave plasma treatment apparatus in which a gas inlet 22 is provided at a microstrip line 11.

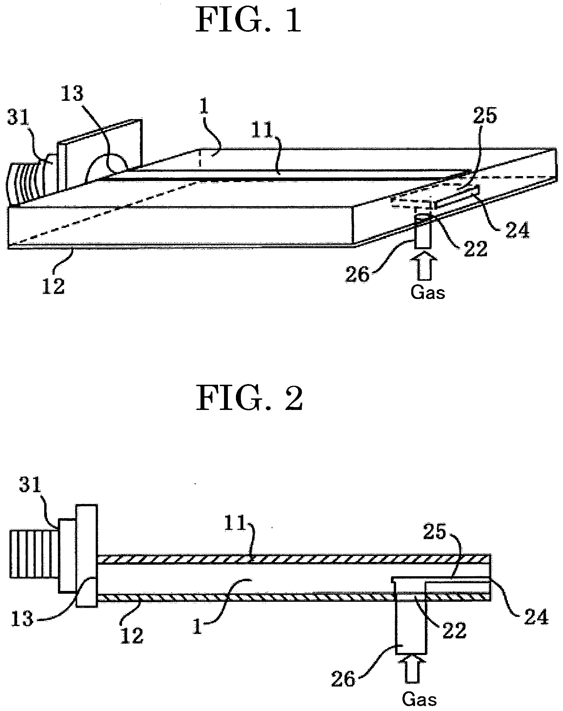

FIG. 1 and FIG. 2 are views illustrating a configuration of a microwave plasma treatment apparatus of an Example of a first embodiment of the present invention. FIG. 1 is a perspective view, and FIG. 2 is a vertical cross-sectional view.

The plasma treatment apparatus of the present embodiment includes, for example, a dielectric substrate 1, a microwave introducing section 13, a microstrip line 11, an earth conductor 12, a gas inlet 22, a nozzle 24, a plasma generating section 25, and a gas supplying unit 26.

As the dielectric substrate 1, a material having a low dielectric loss of a microwave and a high thermal conductivity is preferable. As the dielectric substrate 1, for example, an appropriate material such as alumina, quartz, and sapphire is used. The dielectric substrate 1 may be a flexible material, for example, an appropriate material such as a polystyrol-based material and a polystyrene-based material. The dielectric constant and thickness of the dielectric substrate 1 are influential to the characteristic impedance of a microwave propagation circuit. As the dielectric substrate 1, an appropriate material can be used in consideration of, for example, the microwave propagation characteristic, the shape of the plasma treatment apparatus, and the thermal characteristic of the plasma treatment apparatus. The dielectric substrate 1 may be a single substrate, or a laminate of a plurality of substrates.

The dielectric substrate 1 may be a laminate of a plurality of substrates formed of different materials.

The microwave introducing section 13 is configured to excite a microwave between the microstrip line 11 and the earth conductor 12 at one end of the dielectric substrate 1 as illustrated in FIG. 2. As the microwave introducing section 13, for example, a SMA connect, a SMB connect, a N connect, a BNC connect, and a OSM connect for a microwave coaxial cable can be used.

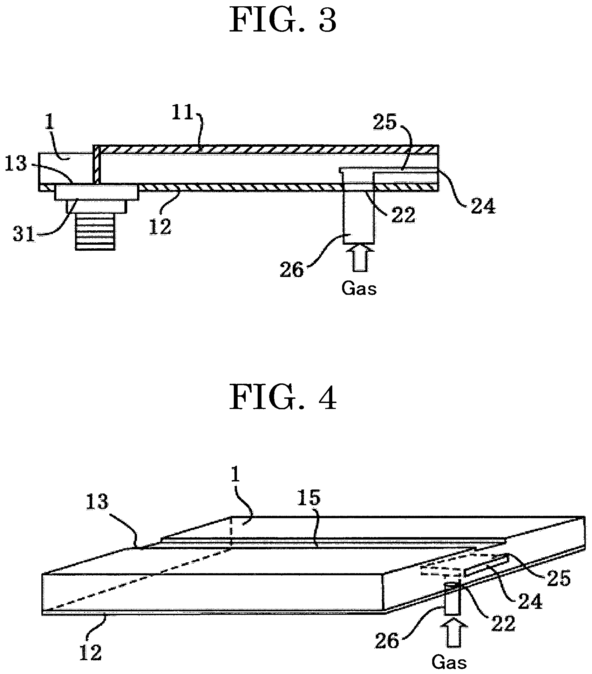

FIG. 3 is a cross-sectional view illustrating a configuration of a microwave plasma treatment apparatus of another Example of the first embodiment of the present invention. As illustrated in FIG. 3, forming a hole in the earth conductor 12 and attaching a microwave connect enables the microwave introducing section 13 to be provided on the surface of the dielectric substrate 1 that is contact with the earth conductor 12.

The microstrip line 11 is provided on a first surface of the dielectric substrate 1 to extend from the microwave introducing section 13 to the other end. Here, a term microstrip is used as an example. However, any other conductor can be appropriately used so long as it is configured to propagate a microwave.

The shape of the microstrip line 11 is an important factor that determines the characteristics of the microwave circuit, such as impedance, electric field distribution, and microwave power distribution ratio. In order to realize generation of a uniform plasma jet, it is necessary to optimize the shape of the microstrip line 11. For designing a microwave circuit of the microstrip line 11, it is possible to appropriately employ wireless communication techniques, because, for example, uniform distribution of a microwave power, matching of characteristic impedance, and matching of impedance have been already established as wireless communication techniques.

As illustrated in FIG. 1 to FIG. 3, the earth conductor 12 is provided from one end to the other end of a second surface of the dielectric substrate 1, which is a surface opposite to the first surface (the surface on which the microstrip line 11 is formed). The earth conductor 12 may be formed of a conductor that entirely covers the second surface of the dielectric substrate 1, or may be formed of a conductor formed on part of the second surface.

As the microstrip line 11 and the earth conductor 12, an appropriate conductor material such as copper, gold, silver, aluminum, and nickel is used. The microstrip line 11 and the earth conductor 12 can be formed on the dielectric substrate 1 using a typical IC production technique such as vapor deposition of a metal and etching.

Alternatively, it is possible to form the microstrip line 11 and the earth conductor 12 by pasting an appropriate conductor plate on the surface of the dielectric substrate 1 with an adhesive.

FIG. 4 is a cross-sectional view illustrating a configuration of a microwave plasma treatment apparatus of another Example of the first embodiment of the present invention. As illustrated in FIG. 4, providing an appropriate groove 15 in the surface of the front surface of the dielectric substrate 1 and embedding the conductor plate of the microstrip line in the groove can provide the microstrip line 11. This method can also be employed in the same manner when providing the earth conductor 12 at a part of the second surface.

The plasma generating section 25 and the nozzle 24 are provided between the microstrip line 11 and the earth conductor 12. The plasma generating section 25 and the nozzle 24 are provided inside the dielectric as illustrated in FIG. 2.

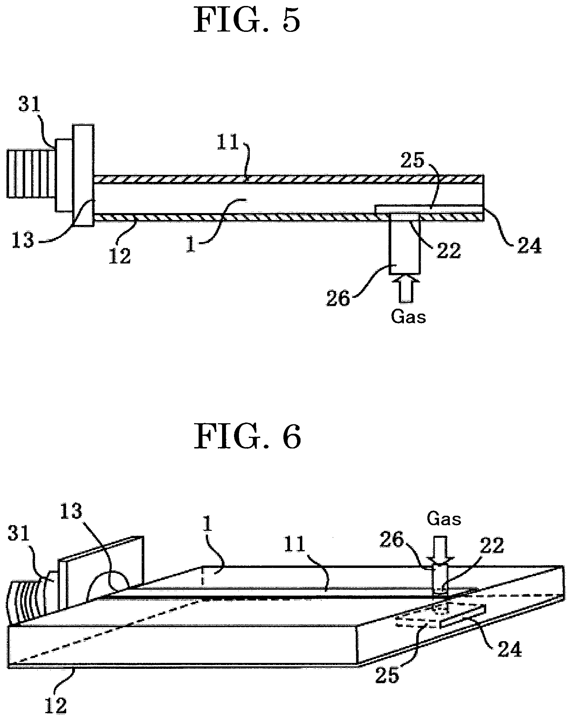

FIG. 5 is a perspective view illustrating a configuration of a microwave plasma treatment apparatus of another Example of the first embodiment of the present invention. As illustrated in FIG. 5, the plasma generating section 25 and the nozzle 24 may be provided in contact with the earth conductor 12. Alternatively, the plasma generating section 25 and the nozzle 24 may be provided in contact with the microstrip line 11, although not so illustrated.

The gas inlet 22 is a hole provided in the earth conductor 12 in order to supply a gas supplied from the gas supplying unit 26 to the plasma generating section 25. Various shapes such as a circle, a triangle, a square, and a star may be used as the shape of the hole of the gas inlet 22.

The diameter of the gas inlet 22 is preferably a size sufficiently smaller than a cut-off wavelength determined depending on a cross-section of the gas inlet 22. This can prevent a microwave from being radiated to the outside of the dielectric through the gas inlet. Furthermore, this can suppress the influence of the gas inlet 22 on the microwave propagation characteristic in the microstrip circuit.

### <Principle by which size of gas inlet is determined>

When a microwave is propagated to a microstrip circuit, a current is induced in the surface of the metal. When a hole is provided in the earth conductor 12 or the microstrip line 11, the flow of the current may be interrupted and the microwave may be radiated to the outside through the hole. In this case, making the size of the hole smaller than the cut-off wavelength prevents the flow of the current from being interrupted and allows the current to flow via the conductor surrounding the hole. As a result, the microwave becomes unable to penetrate the hole, but becomes totally reflected.

The cut-off wavelength is about 1/2 of the wavelength of the microwave inside the dielectric substrate 1, when the shape of the hole is a circle. Hence, making the diameter of the gas inlet 22 sufficiently smaller than 1/2 of the wavelength of the microwave inside the dielectric substrate 1 makes it possible to supply the gas without imparting influence to the microwave propagation characteristic.

It is preferable to provide the gas inlet 22 in the lower surface of the plasma generating section 25. However, it is also possible to provide the gas inlet at an arbitrary position of the earth conductor 12, provide a gas line inside the dielectric substrate 1, and join the gas flow path to the plasma generating section 25. In this case, it is preferable to make the length of the gas line from the gas inlet 22 to the plasma generating section 25 short, in order to suppress influence that may be imparted to the microwave propagation characteristic inside the dielectric substrate 1.

### <Principle of plasma generation>

A microwave to be introduced from the microwave introducing section 13 to the dielectric substrate 1 between the microstrip line 11 and the earth conductor 12 propagates inside the dielectric substrate 1 along the microstrip line 11. The microwave causes a reflected wave at an end portion of the microstrip line 11 and generates a standing wave inside the dielectric substrate 1. The electric field of the standing wave has the maximum value between an end of the microstrip line 11 and an end of the earth conductor 12. This strong electric field excites the gas to be supplied to the plasma generating section 25, to generate a plasma. The generated plasma is blown out from the nozzle 24 together with the flow of the gas. As a result, a plasma jet can be supplied.

### <Embodiment 2>

A plasma treatment apparatus representing a second embodiment of the present invention is a microwave plasma treatment apparatus in which the gas inlet 22 is provided at the microstrip line 11.

FIG. 6 is a perspective view illustrating a configuration of a microwave plasma treatment apparatus of an Example of the second embodiment of the present invention. As illustrated, the gas inlet 22 is provided at the microstrip line 11.

In the second embodiment of the present invention, the microwave plasma treatment apparatus is the same as the first embodiment, except that the gas inlet 22 is provided at the microstrip line 11. Various shapes such as a circle, a triangle, a square, and a star may be used as the shape of the hole of the gas inlet 22. The diameter of the gas inlet 22 is preferably a size sufficiently smaller than a cut-off wavelength determined depending on a cross-section of the gas inlet 22. This can prevent a microwave from being radiated to the outside of the dielectric through the gas inlet.

### <Embodiment 3>

A plasma treatment apparatus representing a third embodiment of the present invention is an apparatus obtained by providing the dielectric substrate 1 with a taper section 14 having a shape gradually decreasing in thickness toward the other end of the dielectric substrate, in the plasma treatment apparatus representing the first or the second embodiment

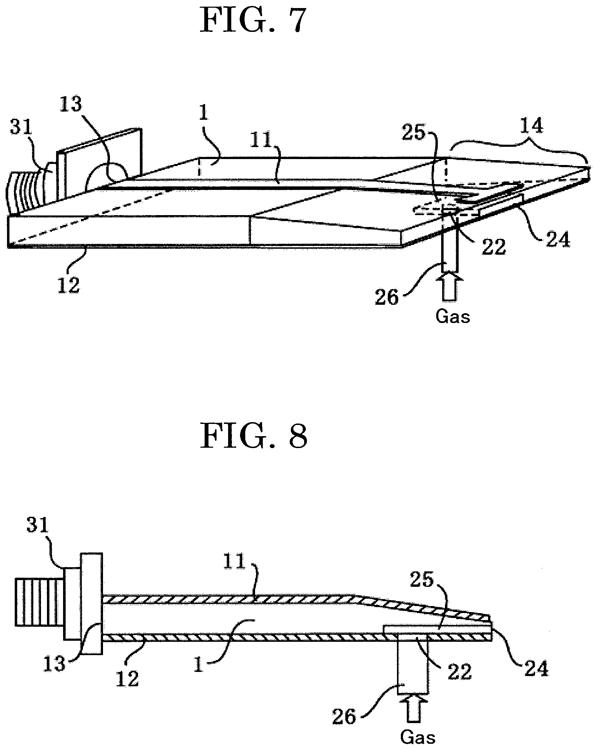

FIG. 7 and FIG. 8 illustrate a configuration of a microwave plasma treatment apparatus of an Example of the third embodiment of the present invention. FIG. 7 is a perspective view, and FIG. 8 is a vertical cross-sectional view.

In the microwave plasma treatment apparatus illustrated in FIG. 7 and FIG. 8, the taper section 14 of the dielectric substrate 1 has a shape obtained by providing only the first surface of the dielectric substrate 1 with an inclined surface. However, the taper section 14 may have a shape obtained by providing the inclined surface of the first surface of the dielectric substrate 1 and an inclined surface of the second surface of the dielectric substrate 1 with the same inclination, or may have a shape obtained by providing only one surface of the dielectric substrate 1, which may be the first surface or the second surface, with an inclined surface.

The electric field of a microwave between the microstrip line 11 and the earth conductor 12 is stronger as the thickness of the dielectric substrate 1 is smaller, i.e., as the distance between the microstrip line 11 and the earth conductor 12 is shorter. According to this principle, the electric field of the microwave is strong at the plasma generating section 25 provided at the taper section 14. This makes it possible to generate and retain a plasma stably at a lower power. Furthermore, the taper section has an effect of suppressing reflection of the microwave at the plasma generating section 25 and the nozzle 24.

The length of the taper section 14 may be set such that the inclination of the taper section 14 becomes 45 degrees. Alternatively, it is possible to appropriately set the length of the taper section 14 in consideration of, for example, the inclination angle of the shape of the taper section 14 and the characteristic impedance. Appropriately setting the inclination angle and length of the shape of the taper section 14 makes it possible to greatly suppress a reflected wave of the microwave to be reflected from the plasma.

As illustrated in FIG. 7, the end of the microstrip line 11 may be formed in an appropriate shape such that the spatial distribution of the electric field of the microwave at the plasma generating section 25 becomes uniform and the electric field intensity becomes strong.

The size of the plasma generating section 25 may be an arbitrary dimension. However, determining the size in consideration of the distribution of the electric field of the microwave makes it possible to generate a more stable plasma while improving the microwave propagation characteristic.

For example, when the depth dimension of the plasma generating section 25 into the inside of the dielectric substrate 1 is set as 1/4 of the wavelength of the standing wave generated inside the dielectric substrate 1, the intensity of the electric field of the standing wave becomes the maximum at the nozzle 24 and the minimum at the internal wall of the plasma generating section. This makes it possible to generate and retain a plasma more stably.

### <Embodiment 4>

A microwave plasma treatment apparatus representing a fourth embodiment of the present invention is an apparatus obtained by providing two or more gas inlets 22 at the earth conductor 12 in the plasma treatment apparatus representing the first to third embodiments.

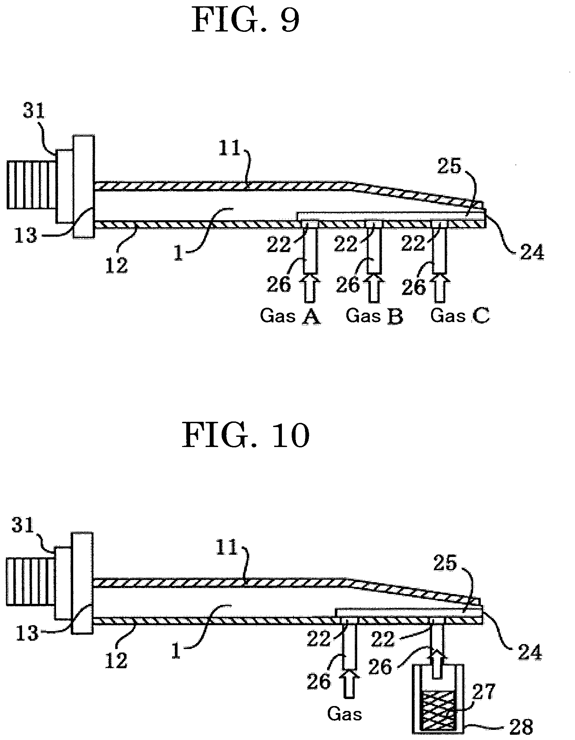

FIG. 9 illustrates a vertical cross-sectional view of a microwave plasma treatment apparatus of an Example of the fourth embodiment of the present invention. As illustrated, the microwave plasma treatment apparatus is an apparatus in which three gas inlets 22 are provided at the earth conductor 12. It is possible to vary the plasma discharge characteristic and the process characteristic by introducing gases of different kinds to the three gas inlets 22.

Generally, an inert gas such as argon Ar and helium He is used in order to generate a plasma stably at a high atmospheric pressure such as the atmospheric pressure. However, there has been a problem that mixing of a molecular gas as a process gas makes the plasma unstable, to make it difficult to retain the plasma.

In the microwave plasma treatment apparatus of the present invention, it is possible to determine the positions from which the gases of various kinds are introduced, in a manner to match the spatial distribution of an electric field in the plasma generating section 25. This makes it possible to supply a process gas into the plasma generating section while retaining a stable plasma with an inert gas.

In the present Example, it was possible to generate and retain a reactive gas plasma stably at a low atmospheric pressure, or a middle atmospheric pressure, or a high atmospheric pressure, by supplying argon Ar or helium He to a gas inlet (gas A) that was at the deepest position from the nozzle 24, hydrogen H₂ to the next gas inlet (gas B), and methane CH₄ to the gas inlet (gas C) that was the closest to the nozzle 24.

The microwave plasma treatment apparatus of the present invention can be applied to plasma CVD for synthesis of carbon materials such as a DLC (diamond like carbon) thin film, a diamond thin film, carbon nanotube, and a graphene film.

As another Example, a plasma treatment apparatus provided with two gas inlets was produced. It was possible to generate a nitrogen plasma stably at a low power at a low atmospheric pressure, a middle atmospheric pressure, or a high atmospheric pressure, by supplying an inert gas (argon Ar or helium He) to the gas inlet that was at the deeper position from the nozzle 24 and a nitrogen N₂ gas to the gas inlet that was the closer to the nozzle 24. Application of this nitrogen plasma to plasma nitriding treatments such as a nitriding treatment of a surface of a metal such as copper and production of a nitride semiconductor is expected.

As another Example of the fourth embodiment of the present invention, a microwave plasma treatment apparatus provided with two gas inlets, one of which was provided with a liquid vaporizing/supplying unit was produced. According to this microwave plasma treatment apparatus, it is possible to provide a plasma treatment apparatus configured to transform a liquid material such as water and ethanol into a plasma.

FIG. 10 is a vertical cross-sectional view illustrating an example of a microwave plasma treatment apparatus of this Example. The microwave plasma treatment apparatus includes a vaporizing/supplying unit 28 for a liquid material 27 at a gas inlet that is the closer to the nozzle 24. In the present Example, it was possible to generate a stable plasma even at the atmospheric pressure, by supplying an inert gas (argon Ar or helium He) to the gas inlet that was at the deeper position from the nozzle 24 and supplying water H₂O to the gas inlet that was the closer to the nozzle 24 by vaporization. This plasma contained at high densities, radicals (chemically active species) such as OH, H, and O that were generated from excitation of water H₂O. Application of the plasma to treatments such as a hydrophilizing treatment and cleaning of a surface of a solid, air cleaning, deodorization, and sterilization/disinfection is expected.

### <Embodiment 5>

A microwave plasma treatment apparatus representing a fifth embodiment of the present invention is an apparatus obtained by providing, for example, a second dielectric substrate 1a, an earth conductor 12a, a gas inlet 22a, a nozzle 24a, a plasma generating section 25a, and a gas supplying unit 26a on the first surface of the dielectric substrate 1 provided with the microstrip line 11, in the plasma treatment apparatus representing the first embodiment, the third embodiment, or the fourth embodiment.

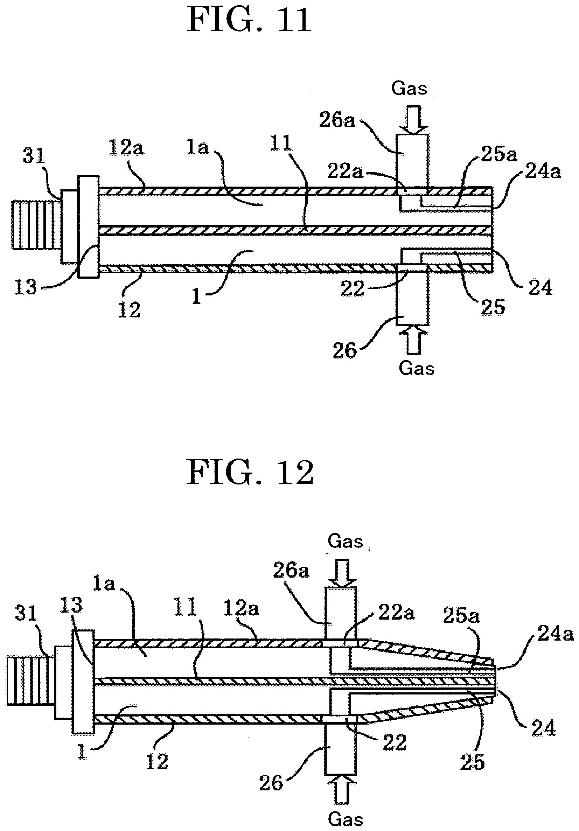

FIG. 11 illustrates a vertical cross-sectional view of a microwave plasma treatment apparatus of an Example of the fifth embodiment of the present invention. FIG. 12 illustrates a cross-sectional view of a microwave plasma treatment apparatus representing another Example of the fifth embodiment of the present invention. This is a vertical cross-sectional view of a plasma treatment apparatus of an Example using a dielectric substrate including a taper section.

In the fifth embodiment of the present invention, the dielectric substrate 1 and the dielectric substrate 1a may be dielectric substrates formed of different materials. However, it is preferable to use dielectric substrates having the same dielectric constant.

### <Principle of plasma generation>

A microwave introduced from the microwave introducing section 13 is introduced into both of the dielectric substrate 1 and the dielectric substrate 1a. The microwaves propagate inside the dielectric substrate 1 and the dielectric substrate 1a respectively along the microstrip line 11.

The microwaves cause reflected waves at an end portion of the microstrip line 11 and generate standing waves inside the dielectric substrate 1 and the dielectric substrate 1a. The electric fields of the standing waves have the maximum values between an end of the microstrip line 11 and an end of the earth conductor 12 and between an end of the microstrip line 11 and an end of the earth conductor 12a.

These strong electric fields excite the gases to be supplied to the plasma generating section 25 and the plasma generating section 25a, to generate plasmas. The generated plasmas are blown out from the nozzle 24 and the nozzle 24a respectively together with the flows of the gases.

### <Embodiment 6>

A microwave plasma treatment apparatus representing a sixth embodiment of the present invention is a microwave plasma treatment apparatus obtained by branching the microstrip line 11 to a plurality of lines from one end toward the other end to enable uniform supply of a microwave power to the plasma generating section 25, in the microwave plasma treatment apparatus representing the first to fifth embodiments.

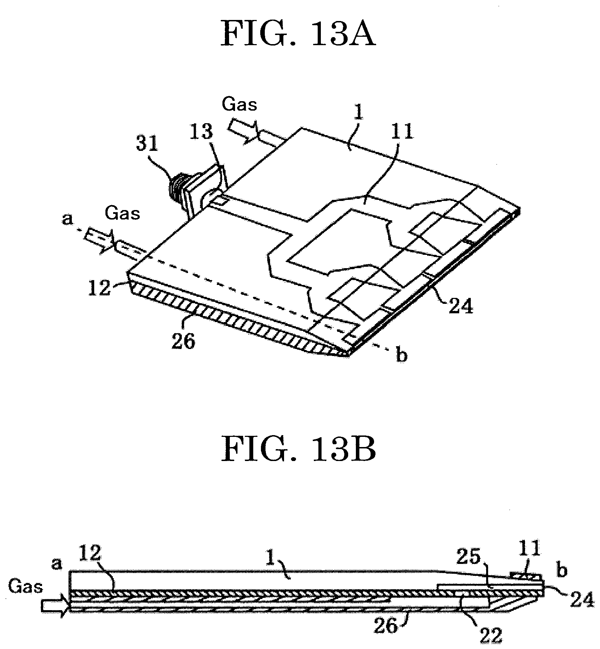

FIGS. 13 illustrate an Example of the sixth embodiment of the present invention. FIG. 13A is a perspective view of a plasma treatment apparatus upsized by providing a microstrip line 11 branched from one microwave introducing section 13 into a plurality of lines, a plurality of gas inlets 22, an elongate plasma generating section 25, an elongate nozzle 24, and a gas supplying unit 26 configured to supply gases to the plurality of gas inlets 22. FIG. 13B is a horizontal cross-sectional view representing a cross-section taken from a to b denoted in the perspective view of FIG. 13A. In the microwave plasma treatment apparatus of the Example of the present invention illustrated in FIGS. 13, the microstrip line 11 is provided such that it is branched twice from one end into four lines, to enable uniform supply of a microwave power to the plasma generating section 25.

Forming the other end of the microstrip line 11 into an appropriate shape makes it possible to increase the impedance and strengthen the electric field of the microwave at the plasma generating section 25. The shape of the Example illustrated in FIGS. 13 is merely an example of the shape. For example, the other end of the microstrip line 11 is divided correspondingly to the four lines in the Example illustrated in FIGS. 13. However, the other end may have a shape integrated into one.

### <Embodiment 7>

A microwave plasma treatment apparatus representing a seventh embodiment of the present invention is an upsized plasma treatment apparatus obtained by employing an arraying technique to arrange side by side, a plurality of microwave plasma treatment apparatuses, each of which is the microwave plasma treatment apparatus representing the first to sixth embodiments, based on their shared use of the dielectric substrate and the earth conductor, to configure a microwave plasma treatment apparatus capable of generating a long, elongate plasma.

### <Upsizing of plasma jet by arraying>

Application of an arraying technique to the first to sixth embodiments of the present invention enables upsizing of a plasma to be blown out and the area to be treated with the plasma.

It is possible to upsize the microwave plasma treatment apparatus of the present invention by appropriately providing a plurality of microstrip lines 11 and an earth conductor 12 on one elongate dielectric substrate 1, a plurality of gas inlets 22 at the earth conductor 12 or the microstrip lines 11 at regular intervals, an elongate plasma generating section 25, an elongate nozzle 24, and a gas supplying unit 26 configured to supply gases to the plurality of gas inlets 22.

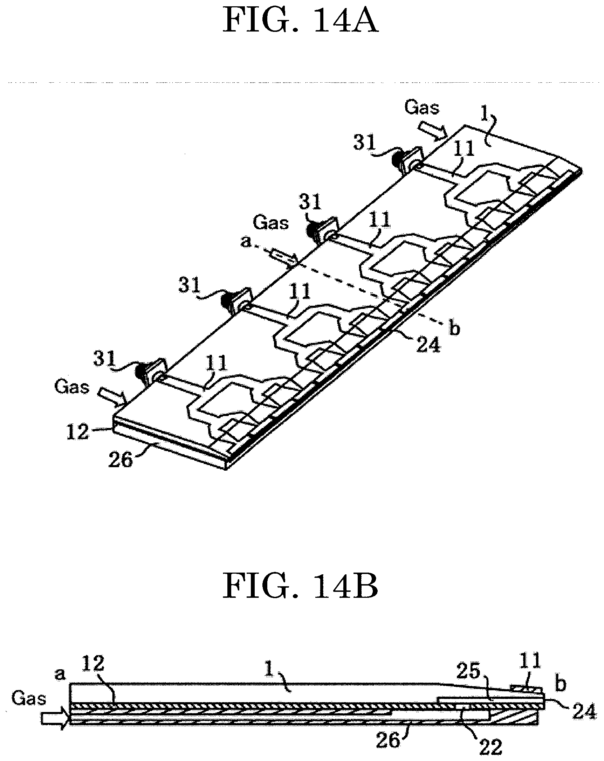

FIGS. 14 illustrate an Example of the seventh embodiment of the present invention. FIGS. 14 illustrate a microwave plasma treatment apparatus obtained by arraying four plasma treatment apparatuses, each of which is the plasma treatment apparatus of the sixth embodiment illustrated in FIGS. 13. FIG. 14A is a perspective view of a microwave plasma treatment apparatus upsized by arraying based on providing of a plurality of microwave introducing sections 13. FIG. 14B is a horizontal cross-sectional view representing a cross-section taken from a to b denoted in the perspective view of FIG. 14A. FIG. 14C is a horizontal cross-sectional view taken at the gas inlets 22. FIG. 14D is a horizontal cross-sectional view taken at the gas supplying unit 26.

The microwave plasma treatment apparatus of the present invention can perform continuous treatment of treatment targets, when a movable substrate stage is provided below a plasma having a wide width. The microwave plasma apparatus of the present invention can generate a plasma at a low atmospheric pressure, or a middle atmospheric pressure, or a high atmospheric pressure, by being supplied with a rare gas, or a reactive gas, or a mixture gas of a rare gas and a reactive gas. Therefore, application of the microwave plasma apparatus to various industrial fields is expected.

### Industrial Applicability

The present invention can provide a microwave plasma treatment apparatus that is configured to be supplied with a rare gas, or a reactive gas, or a mixture gas of a rare gas and a reactive gas to generate a stable low-temperature plasma jet not only at a low atmospheric pressure, but also at a middle atmospheric pressure and a high atmospheric pressure. Furthermore, production of the apparatus and operation costs are inexpensive, and it is possible to generate high density radicals. Therefore, utilization in industrial mass production processes is expected. Moreover, the microwave plasma apparatus of the present invention can be used as a large-scale plasma generating system for surface processes of materials, synthesis of materials, environmental applications, and medical applications.

### Reference Signs List

1: dielectric substrate
11: microstrip line
12: earth conductor
13: microwave introducing section
14: taper section
15: groove
22: gas inlet
23: gas flow path inside a dielectric
24: nozzle
25: plasma generating section
26: gas supplying unit
27: liquid material
28: vaporizing/supplying unit
31: microwave connect

## Claims

1. A microwave plasma treatment apparatus, comprising:
a dielectric substrate;
a microstrip line provided from one end to the other end of a first surface of the dielectric substrate, the first surface being any one of a front surface and a back surface of the dielectric substrate;
an earth conductor provided from one end to the other end of a second surface of the dielectric substrate opposite to the first surface;
a microwave introducing section provided at one end of the dielectric substrate and configured to introduce a microwave to between the microstrip line and the earth conductor;
a plasma generating section that is a space in which a plasma is generated by the microwave introduced from the microwave introducing section, and is a space provided between the microstrip line and the earth conductor;
a gas inlet provided at the earth conductor or the microstrip line and configured to supply a gas to the plasma generating section; and
a nozzle configured to discharge the plasma generated by the gas supplied to the plasma generating section and the microwave from the other end of the dielectric substrate.

2. The microwave plasma treatment apparatus according to claim 1,
wherein a diameter of the gas inlet is smaller than a cut-off wavelength determined depending on a cross-section of the gas inlet.

3. The microwave plasma treatment apparatus according to claim 1 or 2,
wherein the first surface or the second surface of the dielectric substrate is provided with a groove in which the microstrip line or the earth conductor is embedded.

4. The microwave plasma treatment apparatus according to any one of claims 1 to 3,
wherein the dielectric substrate comprises a taper section having a shape gradually decreasing in thickness toward the other end of the dielectric substrate.

5. The microwave plasma treatment apparatus according to any one of claims 1 to 4,
wherein the earth conductor or the microstrip line is provided with 2 or more gas inlets to which gases of different kinds are supplied, to vary a plasma discharge characteristic or a plasma treatment characteristic.

6. The microwave plasma treatment apparatus according to claim 5,
wherein the earth conductor or the microstrip line is provided with 2 or more gas inlets, any one of which is provided with a liquid material vaporizing/supplying unit.

7. The microwave plasma treatment apparatus according to any one of claims 1 to 6, comprising:
a second dielectric substrate provided in contact with a surface of the dielectric substrate provided with the microstrip line;
a second earth conductor provided from one end to the other end of the second dielectric substrate;
a second plasma generating section that is a space provided between the microstrip line and the second earth conductor;
a second gas inlet provided at the second earth conductor to supply a gas to the second plasma generating section;
a second gas supplying unit provided to supply a gas to the second gas inlet; and
a second nozzle configured to discharge a plasma generated by the gas supplied to the second plasma generating section and a microwave from the other end of the second dielectric substrate.

8. A microwave plasma treatment apparatus, comprising:
a plurality of microwave plasma apparatuses,
wherein each of the plurality of microwave plasma apparatuses is the microwave plasma apparatus according to any one of claims 1 to 7,
wherein the plurality of microwave plasma apparatuses are configured to be arranged side by side based on shared use of the dielectric substrate and the earth conductor, to generate a long, elongate plasma.

9. The microwave plasma treatment apparatus according to any one of claims 1 to 8,
wherein the microwave plasma treatment apparatus is configured to be supplied with a rare gas, or a reactive gas, or a mixture gas of a rare gas and a reactive gas to generate a plasma at a low atmospheric pressure, or a middle atmospheric pressure, or a high atmospheric pressure.
